# EUROPEAN PATENT APPLICATION

(11) **EP 4 819 094 A1**
(43) Date of publication of application: **07.10.2026**
(21) Application number: 25168460.1
(22) Date of filing: 04.04.2025
(51) Int. Cl.: G08G 1/01, G06F 30/20

(54) **METHOD AND APPARATUS FOR TRAFFIC SIMULATION**

(71) Applicant: FUJITSU LIMITED, Kawasaki-shi, Kanagawa 211-8588 (JP)
(72) Inventor: Sven van den, BERGHE, Slough, SL1 2BE (GB)
(74) Representative: Haseltine Lake Kempner LLP

(57) **Abstract**

A computer-implemented method for traffic simulation, the method comprising: accepting input of traffic data for a geographic area; executing a traffic simulation, wherein the traffic simulation comprises a main model configured to progress a traffic system through timesteps, and a sub model configured to perform an ancillary traffic simulation function for a later timestep using traffic data corresponding to an earlier timestep; and outputting a status of the traffic system.

## Description

### Field of the Invention

The present invention relates to traffic simulations. More particularly, the present invention relates to a method traffic simulations and related data processing apparatuses, computer programs, and computer-readable storage media.

### Background of the Invention

There exists a trend where the real world may be represented as a digital world. Concepts such as Smart Cities, Digital Twins (DTs), and the Metaverse have received particular attention, at least in part due to the new and improved technologies that enable advancements within these concepts, such as technologies related to Internet of Things (IoT), 5th Generation technology standard for telecommunications (5G), Artificial Intelligence (Al), and quantum computing.

For improvements related to transport, smart traffic systems are used to deliver a wide range of services to varied users at scale and in real time (or at least fast enough for effective action to be taken). It is desirable for systems to deliver a wide range of services, created by complex processing of primarily real-time sensed data acquired from sources in (or serving) a transport network (for example, from roads and from vehicles). The services are often required in "real time", such that immediate action to be taken by the users of the services. There are diverse data sources, generating different types of data at different rates. The services are also diverse and complex, using the data in a wide range of different ways.

As an example, a transport authority for a large city may create a simulation in the form of a system DT of its public transport infrastructure that provides a real-time virtual model of the flow of traffic throughout the city. The virtual model may be driven by data generated from a wide variety of sources in real time, including: vehicle movements from in-vehicle GPS, roadside sensors, CCTV analysis, routing requests, live dispatches of public transport, etc.; the state and operation of infrastructure, such as traffic lights; and movements of people, from mobile GPS, ticketing activity, CCTV, etc.

Agent-based modelling (ABM) is a computational modelling framework for simulating the actions and interactions of autonomous agents (both individual and collective entities such as organizations or groups). ABM is a modelling paradigm that incorporates an agent which is a piece of code that represents the individual entity of interest and an environment in which the agent(s) reside and interact. ABM has enabled computational social scientists and others to simulate a wide range of empirically observed phenomena within a computational sandbox environment, stress testing a system before adoption. Typically, an agent-based model is made up of two components, the agent and environment. The agent is an autonomous individual, often described as a software object that represents behaviour at the individual level. For example, an agent may represent a person, with characteristics such as age, height, weight. The environment represents some constrained space that may either be abstract or based on empirical data of the built-environment, within which the agents operate. With its widespread cross-disciplinary adoption, challenges of the ABM approach have been identified and investigated at length. One of the most prominent of these is the computational tractability of simulating intensive tasks. Sometimes, to overcome this challenge, modellers opt to reduce the complex representation of the real-world system by approximating complex behaviours or reducing the population of agents to the detriment of the simulation outcomes.

Modern ABMs are composed of rule-following agents (usually encoded as algorithms) that dynamically interact with their environment and/or each other. The state of each agent is usually contained in their state variables, which may be modified based on the interactions of the agent. The agents simulate local (microscopic) interactions that may lead to complex, emergent phenomena at various spatio-temporal scales. Recent increases in the availability of computing power have increased the uptake of such methods greatly increasing their popularity in research.

Microscopic ABMs take a detailed, bottom-up approach to modelling vehicular traffic. Unlike macroscopic models that focus on traffic flow as a whole, microscopic ABMs treat individual vehicles (and sometimes pedestrians) as independent agents with their own characteristics and decision-making capabilities. This allows for a more realistic simulation of traffic behaviour, taking into account factors like: individual driver behaviour (each agent may have different levels of aggression, patience, and skill, leading to diverse driving styles); vehicle characteristics (different vehicle types (cars, trucks, motorcycles) may have different acceleration, deceleration, and turning capabilities); environmental factors (traffic signals, lane markings, road geometry, and weather conditions may all impact agent behaviour); interactions between agents (agents may react to each other's actions, like changing lanes, braking, or merging, leading to emergent traffic phenomena like congestion and bottlenecks).

Simulations of the evolution of complex social systems, such as Smart Cities and social Digital Twins, over time are often made up of functional components in the form of a main model, which progresses the overall simulated system through time, and sub models, which simulate specific ancillary behaviours of components of the simulated system. Conventional processing techniques execute these models sequentially, such that the time taken to evolve the simulated system through a designated number of timesteps and to reach a resultant system state is typically the sum of the execution times of all main model components and sub model components.

It is desirable to provide techniques that offer improvements in realistic simulations of scenarios in digital representations of the real world.

### Summary of the Invention

The invention is defined in the independent claims. Specific embodiments are defined in the dependent claims.

According to an aspect of the invention, there is provided a computer-implemented method for traffic simulation, the method comprising accepting input of traffic data for a geographic area; executing a traffic simulation, wherein the traffic simulation comprises a main model configured to progress a traffic system through timesteps, and a sub model configured to perform an ancillary traffic simulation function for a later timestep using traffic data corresponding to an earlier timestep; and outputting a status of the traffic system.

Embodiments of another aspect of the invention include a data processing apparatus, which comprises a memory, a plurality of processing units, and means for accepting input. The memory stores computer-executable instructions to carry out a computer-implemented method for traffic simulation. The plurality of processing units and the means for accepting input are configured to execute the instructions.

Embodiments of another aspect of the invention include a computer program comprising instructions, which, when executed a data processing apparatus, causes the data processing apparatus to execute a computer-implemented method for a traffic simulation.

Embodiments of another aspect of the invention include a non-transitory computer-readable storage medium comprising instructions, which, when executed by a data processing apparatus, cause the data processing apparatus to execute a computer-implemented method for traffic simulation.

The invention may be implemented in digital electronic circuitry, or in computer hardware, firmware, software, or in combinations thereof. The invention may be implemented as a computer program or a computer program product, i.e., a computer program tangibly embodied in a non-transitory information carrier, e.g., in a machine-readable storage device or in a propagated signal, for execution by, or to control the operation of, one or more hardware modules.

A computer program may be in the form of a stand-alone program, a computer program portion, or more than one computer program, and may be written in any form of programming language, including compiled or interpreted languages, and it may be deployed in any form, including as a stand-alone program or as a module, component, subroutine, or other unit suitable for use in a data processing environment. A computer program may be deployed to be executed on one module or on multiple modules at one site or distributed across multiple sites and interconnected by a communication network.

Method steps of the invention may be performed by one or more programmable processors executing a computer program to perform functions of the invention by operating on input data and generating output. Apparatus of the invention may be implemented as programmed hardware or as special purpose logic circuitry, including e.g., an FPGA (field programmable gate array) or an ASIC (application-specific integrated circuit).

Processors suitable for the execution of a computer program include, by way of example, both general and special purpose microprocessors, and any one or more processors of any kind of digital computer. Generally, a processor will receive instructions and data from a read-only memory or a random access memory or both.

The invention is described in terms of particular embodiments. Other embodiments are within the scope of the following claims. For example, the steps of the invention may be performed in a different order and still achieve desirable results.

Aspects of embodiments have been described using such terms as "computing means" and "processing unit". The skilled person will appreciate that such functional terms and their equivalents may refer to parts of the system that are spatially separate but combine to serve the function defined. Equally, the same physical parts of the system may provide two or more of the functions defined. For example, separately defined means may be implemented using the same memory and/or processor as appropriate.

### Brief Description of the Drawings

Reference is made, by way of example only, to the accompanying drawings in which:
FIGURE 1 is a schematic example of the interaction between a main model component and two sub model components in a traffic simulation;
FIGURE 2 is a schematic example of the progression of main model components and two sub model components in a traffic simulation;
FIGURE 3 is a schematic example of the progression of one main model timestep in a traffic simulation;
FIGURE 4 is a flowchart of a general method for traffic simulation according to embodiments;
FIGURE 5 is a comparative schematic of the progression of a traffic simulation using conventional techniques and using a technique according to embodiments;
FIGURE 6 is a flow diagram of a traffic simulation process as performed by a route planning sub model according to embodiments;
FIGURE 7 is a flow diagram of a traffic simulation process as performed by a main model according to embodiments;
FIGURE 8 is a flow diagram of a traffic simulation process as performed by a main model, with dynamic adaptation of times according to embodiments;
FIGURE 9 is a comparative schematic example of the progression of a traffic simulation with and without dynamic time interval adaptation; and
FIGURE 10 is a block diagram of computational means for implementation of methods according to embodiments.

### Detailed Description

Developments in sensor- and communication-based technologies and in the "Internet of Things", including the acquisition and processing of large amounts of data and the understanding and modelling of human behaviour have enabled increased understanding and management of the evolution of complex social systems (CSS) through simulations. A typical structure of a CSS simulation may include a main model that represents all the entities or agents within the simulation and advances or progresses the overall model (that is, the underlying simulated system) in time by, for instance, considering the interactions between the entities and their environment. The behaviour of the entities may be internally complex and require individualistic modelling. So, a CSS simulator may be considered as comprising a main model component and one or more sub model components.

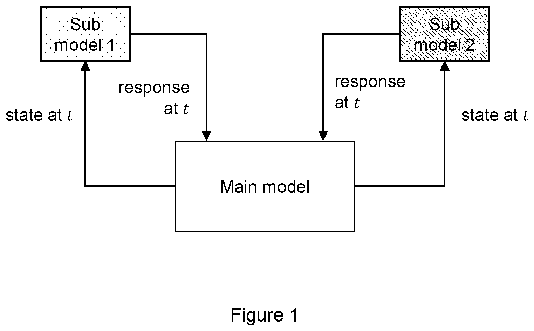

FIGURE 1 provides a schematic example of the interaction between a main model component and two sub model components. These model components interact, with the main model passing the state of entities at a time (t) to the sub models and subsequently receiving the modelled response of the entities in view of the passed state.

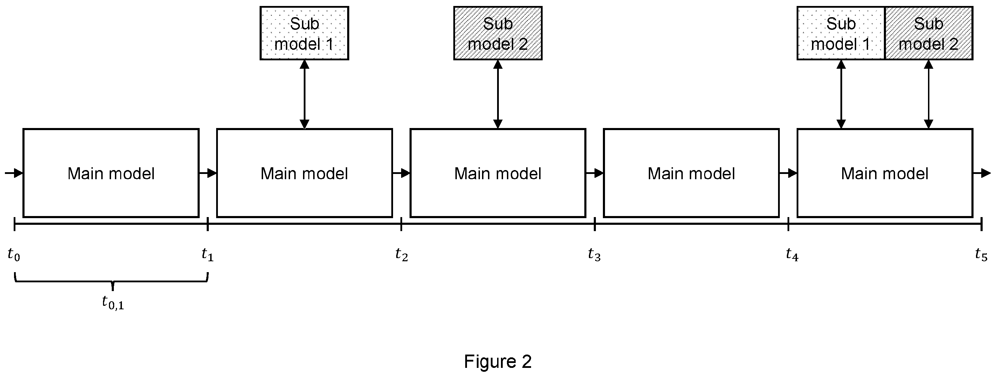

**As the CSS** simulation advances in time, the main model may be executed at discrete timesteps and the main model may - at possibly different timesteps - call sub models to determine simulated entity responses. In known techniques, the state(s) passed to sub models by main model components are associated with the current simulation time. FIGURE 2 provides a schematic example of the progression of a CSS simulation including a main model with multiple main model components and two sub model components. As seen in Figure 2, in timestep *t*_{1,2} (i.e., the time interval between timepoints *t*₁ and *t*₂), the main model sends the state of the relevant simulated entity at *t*_{1,2} to a first sub model. Similarly, in timestep *t*_{4,5}, both the first sub model and a second sub model receive state data in *t*_{4,5} from the main model. Consequently, in known techniques, the CSS simulation cannot proceed to the next timestep until processing of all the main and sub models has completed.

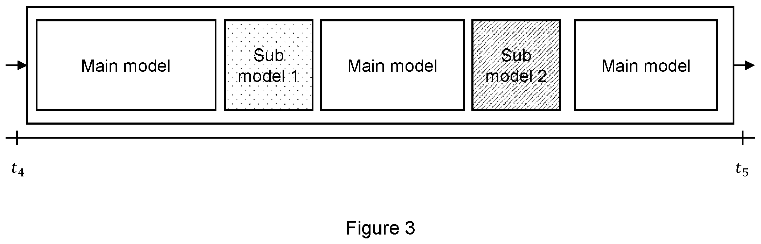

FIGURE 3 is a schematic example of the progression of the CSS for the timestep *t*_{4,5}. As seen, the requirement of sequential processing introduces a bottleneck in simulation efficiency. In other words, in known techniques, the main model and all sub models are required to be synchronised; that is, the sub models must use values for the state of the simulated system that are valid for the current simulation timestep (*t*_{4,5}) and so can only be computed when this state is known. Synchronisation means that no model component (main or sub) is able to advance to the next discrete timestep unless all other model components also do so. This constraint results in models being executed sequentially.

Known techniques enable the concurrent execution of CSS simulations. For example, within a model component, the underlying data structure may allow for (or be suitably adaptable to allow for) calculations to be executed concurrently using, for instance, multiple operating system threads or multiple processors, (including GPUs, for example). Further, some simulated CSS systems often include many independently operating "agents", whose interactions are weak so that the synchronisation constraints discussed above can be relaxed and it is possible to execute computations on these agents concurrently. However, such known techniques, operate within (or on) a sub model itself and do not remove the requirement that the sub models be executed sequentially with main model components.

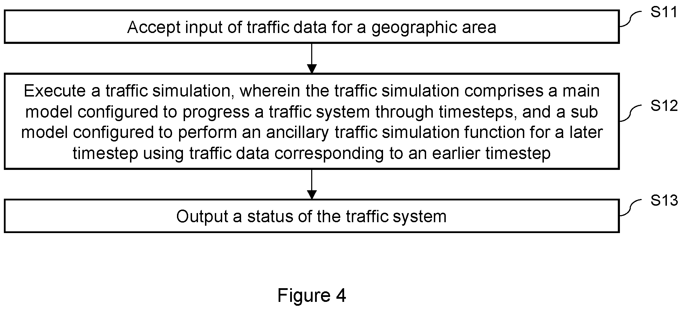

FIGURE 4 provides an overview of a general method for traffic simulation, which addresses the above-described shortcomings of known simulation techniques. The method may be implemented by computing means. At S11, the computing means accepts input of traffic data for a geographic area or region. The traffic data may be vehicular data and/or pedestrian data. The traffic data may include data that is obtained from one or more sensors within the given geographic area (the region of the traffic simulation). The traffic data may further include data related to current or upcoming weather, seasonality, prearranged events (such as concerts or sporting events), mobility flow, and correlated patterns in traffic from other geographic areas (adjacent geographic areas and non-adjacent geographic areas). The traffic data may relate to survey data, indicating - for example - the business of road segments or the use of public transport systems. The input traffic data for the geographic area may be real-life data, reflecting the state of traffic in real-time.

At S12, the computing means executes or initialises a traffic simulation. The traffic simulation comprises a main model, which is configured to progress a simulated traffic system in the geographic area though a series of timesteps. The main model may be considered to comprise a plurality of main model components, each distinct main model component corresponding to a distinct timestep for the simulation (i.e., a first main model component corresponding to a first timestep, a second main model component corresponding to a second timestep, etc.).

The traffic simulation further comprises at least one sub model component, which is configured to perform an ancillary traffic simulation function for a (later) timestep. The sub model component performs the ancillary traffic simulation function using traffic data corresponding to an earlier timestep (that is, earlier relative to the later timestep for which the ancillary traffic simulation function is performed). For example, the sub model component may perform an ancillary traffic simulation function for the simulated traffic system in a second timestep using traffic data acquired in and corresponding to a first timestep. The traffic data used in this context may accordingly be referred to as lagged traffic data.

The main model traffic simulation may be a microscopic, agent-based simulation, in which each agent object is representative of a traffic participant and that traffic participant's associated data. For instance, an agent object may be a software object that represents behaviour of a single vehicle (where the associated data includes that vehicle's speed and position), or may be a software object that represents a segment of road within the geographic region. Depending on the complexity of the simulation, there may be many hundreds or thousands of agent objects.

In an example implementation, each agent object may be allocated to one more of a plurality of processing units. These processing units may be, for instance, central processing unit (CPU) or a graphical processing unit (GPU): a specialised electronic circuit initially designed to accelerate computer graphics and image processing (either on a video card or embedded on the motherboards, mobile phones, personal computers, workstations, and game consoles).

The processing units may be individual cores, groups of cores, threads, thread blocks, or warps composed of parallel threads.

In one example, a main model may simulation be transformed from a system of ordinary different equations (ODEs) into an equivalent description of agent's behaviour and encoded into a template-based ABM framework, which allows the traffic model to process each agent's calculations via a core on a GPU. GPUs process calculations more efficiently and sport the inherent ability to parallelise calculations. In this manner, the GPU may be used as a general purpose GPU (GPGPU), where general purpose computing is performed on GPUs, performing computation in applications traditionally handled by the CPU.

While conventional techniques are known in which parallel execution may be performed within a single simulation model, the present techniques targets simulations that execute multiple model components within a single process and exploits the fact that these models may be executed concurrently (optionally in parallel).

In an example implementation, a microscopic traffic simulation or flow model is a mathematical traffic model that simulates single vehicle-driver units, so the dynamic variables of the models represent microscopic properties like the position and velocity of the single vehicles.

As described above, a sub model in the present context is configured to perform an ancillary traffic simulation function. One example ancillary traffic simulation function is vehicle routing (or rerouting). For example, consider the action of changing the route taken by a vehicle in response to "live" traffic conditions using a route planning sub model. The data comprising the "live" conditions on which the route planning will take place will have passed from sensing originators (e.g., other vehicles, traffic cameras, on-road loop detectors) to a central data centre where the data may be aggregated. Aggregated data may then be passed through a route planner sub model to determine the optimal route for these conditions. Data from originators may be obtained at predetermined intervals (not continuously). Additionally, to save computing resources, the route planning sub model may be executed only after a predetermined interval of time has passed. As a result, the route planning takes place using out-of-date data and not using data reflective of the actual conditions at the time at which route planning is to take place.

A further example ancillary traffic simulation function is participant behaviour determination. Simulation of the time evolution of social systems may model the behaviour of traffic participants and how the behaviour may change by making decisions in response to nudges.

On the whole, these are conscious rather than reactive decisions - involving absorbing information and considering consequences - which take a noticeable period of time. As a result, these decisions are based on lagged state data. An example of behavioural determination is a decision by a traffic participant to change a route in response to traffic conditions. Several factors, including expected travel time, road conditions, and reliability of traffic information, play a part in the determination. As a result, for example, many traffic participants deciding to change route in response to a traffic jam may lead to congestion on minor routes. In another example case, traffic congestion could be eased by encouraging drivers to use public transport through financial incentives; a sub model may perform an ancillary traffic simulation function that determines the likelihood of a traffic participant to accept such financial incentives.

Broadly, in an ABM, the main model may aim to re-create traffic movement on a microscopic level over a real-world traffic network. Each traffic participant (e.g., vehicle) may be modelled separately in respect of its speed and position while moving along a street network that contains lanes, intersections, traffic lights, speed limits, as well as other real-world attributes that factor into a participant's movement from one point of the network to the other. A participant is expected to obey the set rules while active in the simulation.

At S13, the computing means outputs a status or state of the traffic system. The output status corresponds to the simulated traffic system within the geographic area, incorporating the results of the sub model (and ancillary traffic simulation function thereof). The computing means may output the status of the traffic system to further computing means, which may use the status of the traffic system to generate instructions for implementation of changes or interventions in the real-life geographic area corresponding to the simulated geographic area. Additionally or alternatively, the computing means may output the status of the traffic system to a display, for example to enable a user to study the simulated geographic area.

Using the techniques herein, sub models may be executed using lagged - rather than current time - input traffic data. Running sub models using lagged traffic data ensures that the sub models may be executed concurrently with the main model (or components thereof). That is, in some embodiments, the main model may progress the traffic system and the sub model may perform the ancillary traffic simulation function in parallel.

Techniques herein allow replacement of the execution of accurate, but computationally expensive, sub models with approximate, faster, simplifications of the sub model if is desired to reduce the lag of the values produced.

Relative to conventional techniques, the techniques herein decrease the response time of simulations. The uptake and utility of simulations of complex systems is increased by these faster response times, enabling real-time interventions. In many applications, these simulations are used to explore the impact of a number of different interventions into the system, each intervention requiring a different simulation to be executed. These techniques reduce the computational load of each simulation thus enabling more simulations to be run with the same resources and thereby increasing the number of options that can be explored.

The techniques herein allow users to construct real-world transport network simulations on an unprecedented scale. These techniques enable simulations to operate at speeds that exceed real-time modelling, thereby significantly enhancing the efficiency and effectiveness of simulation processes.

Known simulation engines are hampered by scalability issues that limit their capacity to model complex and extensive systems. The techniques herein effectively aid in eliminating these scalability constraints, enabling users to simulate large-scale transport networks without compromising the quality or accuracy of the results.

The skilled reader will appreciate the applicability of the techniques herein to such fields as traffic planning and engineering, where the techniques may be used for evaluating the impact of road infrastructure changes, traffic management strategies, and public transportation services. An example application in this context is traffic flow with dynamic route finding, where the traffic flow and route finding may be executed concurrently. In the field of autonomous vehicle development, testing and evaluating the behaviour of self-driving cars in simulated environments may be provided by techniques herein. In the field of urban planning, the techniques herein allow for studying the impact of transportation systems on land use, air quality, and energy consumption.

Beyond transport networks, the techniques herein may be extended to model other systems of mass facilitation. This versatility makes the approach a valuable asset for diverse industries and sectors seeking to simulate and optimise various complex systems. This discussion focusses on simulation of road traffic, but the invention can be applied to other CSS simulations that have a main simulation model, for which underlying main model components may have inputs that are the output of other complex sub models. The sub models themselves may have input from other main model components. Examples include disaster evacuation models, people flow inside buildings, and many other social DT applications.

The techniques herein provide for data input and data output that allows reading real-world traffic networks, recognition of agent origin and destination data and agent descriptions, as well as other adjacent process descriptions and algorithms within the traffic simulation model.

CSS models may be complex, requiring a significant amount of processing to execute to completion. The total time taken to execute a known, conventional CSS simulation may then be inordinately long and is determined by the times taken for sequential execution of each model component for discrete timesteps. This may reduce the practicality of CSS simulations since the execution time may be too long to effectively provide responses in time, such that actions may be taken in the real world to react to simulated conditions. In the case of off-line simulations, fast response times are important in order to increase the number of different options to change the system that may be evaluated by simulation in the same amount of time. Consequently, the techniques herein according to embodiments provide procedures that reliably reduce the time taken to execute CSS simulations.

In some embodiments, the step of executing the traffic simulation includes a determination step, in which the computing means determines if the ancillary traffic simulation function (or another, distinct ancillary traffic simulation function) for a preceding timestep has completed. In the event that the ancillary traffic simulation function for the preceding timestep is ongoing (has not yet completed), the computing means may perform a wait operation. When the ancillary traffic simulation function for the preceding timestep is complete, the computing means may go on to perform the ancillary traffic simulation function for the later timestep.

For example, the main model component associated with a particular timestep may require the results of an ancillary traffic simulation function in order to complete any processing steps therein and therefore it is advantageous to await the availability such results before the simulation progresses the main model to a subsequent step.

In some embodiments, computing means may further perform dynamic adaptation (increase or decrease) of the time interval between the times associated with the simulated system state used by the sub models and the times that the results of the sub models are required. In this way, increasing the time interval provides the sub model with more time in which to finish any ancillary traffic simulation function before the sub model's results are required at the next time step of the simulation. Increasing the time interval may be implemented, for instance, by associating the sub model with a past timestep (preceding the earlier timestep, with which the sub model is otherwise associated). That is, with dynamic time interval adaptation, the sub model may be configured to perform the ancillary traffic simulation function for the later timestep using traffic data corresponding to the past timestep. In one example, dynamic adaption of time intervals may be implemented by configuring the computing means to perform a continuous "look ahead" process, which identifies sub models that are expected to require a prolonged time to complete and thereby cause the main model to perform a wait operation. The time interval may then be pre-emptively increased for the upcoming sub models. The time interval may be reduced in an analogous manner. This technique reduces the propagation delay, making the overall simulation computation faster.

In some embodiments, the traffic simulation may comprise multiple sub models. The multiple sub models may be configured to perform the same ancillary traffic simulation function or distinct ancillary traffic simulation functions.

In some embodiments, traffic data comprises data obtained from or corresponds to a Digital Twin (DT) of the geographic area under consideration. The method thereby creates comprehensive and realistic DTs, offering a high level of reliability and accuracy in modelling real-world systems. A DT in this context is a digital model of the traffic system that serves as the effectively indistinguishable digital counterpart of the traffic system for such purposes as simulation, integration, testing, monitoring, and maintenance of the real-life system.

In some embodiments, traffic data comprises sensor data. This sensor data may be real-world sensor data acquired in real-time from any or all of the following: GPS sensors or antennas; cellular network sensors or antennas; loop sensors; camera sensors; and vehicle parking sensors. The sensors may be on-board sensors, for example a GPS sensor or cellular (telecommunications) sensor provided within or on a vehicle or pedestrian, configured to transmit the position of the vehicle or pedestrian. Antenna signal triangulation may be used to determine traffic position. Alongside GPS data and cellular data, any other floating car data may be suitably used. Camera sensors may be used to remotely accumulate image data, upon which image processing techniques such as object detection may be used to provide vehicle or pedestrian positioning data. Vehicle parking sensors (either on-board or remote to the vehicle) may be used to indicate the parked position of vehicles, thereby providing, for example, parking facility occupation level. Of course, the sensor data may be historical sensor data, representative of a traffic system at some point in the past.

In some embodiments, the traffic simulation main model may include a car-following model, used to model or determine how traffic participants (e.g., vehicles or pedestrians) follow one another on a roadway or path. For instance, the main model may determine the speed of a **vehicle in** relation to the vehicle ahead of it. One such implementation of a suitable car-following model is Krauss' car-following model, which facilitates a no-collision environment. Of course, alternative car-following models (including Gipps' model (Gipps, 1981)) may be used. In addition, the traffic simulation main model comprises either a lane-changing model or a junction (or intersection) management model (or both). A lane-changing model is used to determine lane choice on multi-lane roads and speed adjustments related to lane changing. A junction management model is used to determine the behaviour of traffic participants at different types of intersections in regard to - for example - right-of-way rules, gap acceptance, and avoiding junction blockage.

In one implementation, SUMO may be used as the traffic simulation main model and lane-changing rules and intersection mechanics may follow those described in the work of Erdmann, J ("SUMO's lane-changing model", 2014) and Erdmann, J. & Krajzewicz ("SUMO's road intersection model", 2011). SUMO may be used to update a vehicle's (or traffic participant's) speed and position in a series of main model components. Each vehicle state is sequentially updated through each simulation step - this is expected, at best, to show a complexity growth of *O*(*n*)*,* where *n* is the number of vehicles simulated. Although this is a moderate growth factor, larger simulation models quickly end up with scalability problems, and become computationally intractable for real-time simulation requirements. The techniques herein allow for reduction in simulation duration.

The example lane-changing rules and intersection mechanic models are built on top of earlier models used in SUMO, adding internal junction support to better represent vehicle behaviour while navigating complex intersections, as well as an improved, more complex hierarchy of lane and velocity selection choices that include strategic, tactical, cooperative and regulatory triggers. These updated rule sets are used by default in the latest version of SUMO and are meant to improve the accuracy of an already reliable model.

SUMO's lane-changing model determines vehicle's lane choice for a single simulation stem based on both the route of the vehicle, as well as historical and current traffic conditions in the vehicle's surrounding, and computes necessary changes in velocity for the vehicle itself and for obstructing vehicles in order to promote execution of aforementioned choice In this model, the road network consists of edges, which are one-way street segments with a fixed number of lanes and speed limit. Each edge is made up of parallel lanes. Vehicles are defined by a route comprising a sequence of edges, and during simulation, they move along lanes with some freedom in choosing which lane to use (unless restricted). Connectivity is defined at the lane level, where each lane may connect to zero or more other lanes. If a vehicle's current lane does not connect to the next edge on its route, it needs to change lanes to continue.

The lane-changing model considers the vehicle in front (leader) to determine a vehicle's speed, regardless of whether it's in the same lane or the preferred next lane. The car-following model defines the follower's speed based on the leader. Lane changes are only possible if there is enough space in the target lane and if the vehicle would not get too close to the leader or follower in that lane (as defined by the car-following model). If these conditions are not met, the vehicle experiences a "blocking leader" or "blocking follower".

SUMO's junction management model represents intersections as nodes, with incoming and outgoing edges (roads with one or more lanes). Inside an intersection, "internal lanes" connect incoming lanes to outgoing lanes. Vehicles move across these internal lanes just like they would on regular lanes. This allows for detailed vehicle tracking and modelling of intersection capacity.

Each lane may have multiple potential next lanes. These connections are defined by "links," forming a "lane-graph" where lanes are connected, distinct from the "intersection-graph" where intersections are connected by roads.

At most intersections, vehicles wait at the stop line before entering, allowing them to cross without conflicting traffic. However, for specific situations like left (or right) turns, SUMO allows waiting in the middle of the intersection. This is modelled by splitting internal lanes and introducing an "internal intersection" within the main one. Vehicles using these lanes pass the initial entry point and wait at the internal intersection instead. The manner in which right-of-way is determined at these internal intersections is the same as at regular ones. Again, the reader is directed to the work Erdmann, J. & Krajzewicz ("SUMO's road intersection model", 2011) for a full derivation and explanation of one example junction management model.

As a worked example of an implementation, illustrating the processing of a CSS simulation, consider an example of traffic flow simulation throughout geographic a region, including dynamic responses to condition changes such as traffic accidents, closed roads, and increases and decreases in the number of vehicles on the road. These condition changes may result in significantly increased travel times for drivers on their originally planned routes. The routes that drivers will choose in these situations may change dynamically in response to traffic conditions. A CSS simulation of the traffic includes a main model of the road network including vehicles on the network, their interactions with each other, and the components of the road network. **Sub models** in this example include consideration of driver behaviour (a driver's preference for certain road types, for instance). In addition, to allow for dynamic rerouting of journeys, it is desirable to also provide a sub model to find the optimal route given current traffic conditions.

With reference once again to FIGURE 1, in a conventional simulation technique, the main model is a simulator of traffic (using, e.g., SUMO as described above), maintaining quantities such as vehicle location and speed. Sub model 1 models driver behaviour and reactions, such as the conditions under which a route is changed (e.g., duration exceeds some predefined threshold), receiving the traffic conditions proximate to the vehicle, and responding with a decision to stay on the current route (or not). Sub model 2 is a route planner, receiving the traffic conditions in the simulated region and responding with the current fastest routes for the vehicles in the network.

Route optimisation is a complex computational problem and in CSS simulations of dynamic traffic the execution of a route planner may dominate elapsed execution times leading to very slow response times when executed in the conventional sequential manner as exemplified in FIGURE 3.

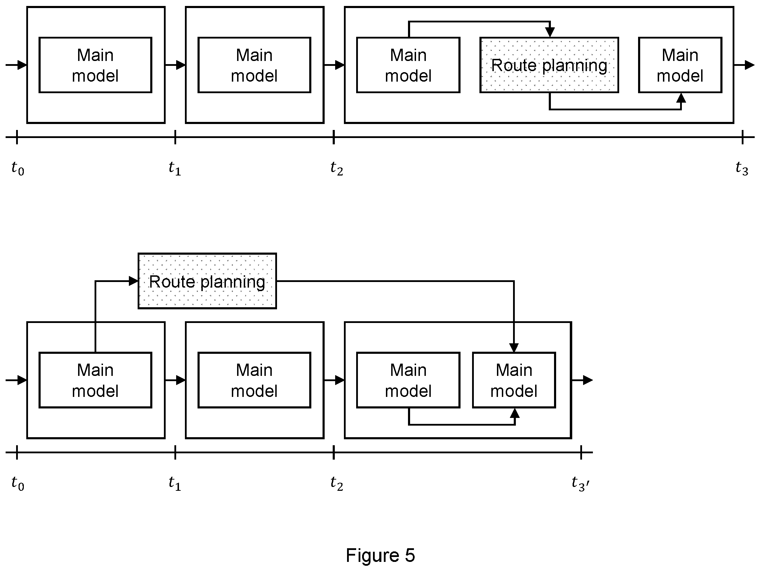

Conventional CSS simulations require that sub models execute aspects of a simulation and return responses at the same simulated time as the main model. For example, FIGURE 5 (top panel) demonstrates the need for the conventional CSS simulation to perform route planning sequentially within the same timestep (*t*_{2,3}) as aspects of the main model. Sequential execution requires simulation times to be synchronised across the main model and all sub models.

This requirement is not necessary, however, with techniques according to embodiments, when simulating many real world situations: real world conditions mean that there is often a lag between data acquisition and actual conditions. That is, the processes modelled by sub models may not be required to operate with the same state (data) as with the main model. In many cases, in real world systems that are modelled in CSS, simulations do not have access to or do not use the most currently available information. That is, the information processed by sub models may be lagged relative to the current time, at which the consequences of any applied actions are assessed.

In the real world, there will rarely be information available to the components of a simulated system that concerns the state of the simulated system at the present moment; data from different sources will almost inevitably have a time delay. The time delayed data will relate to some time and some state of the system in the past. The delays arise due to such factors as **the time taken** to obtain a measurement, the time taken to transmit data (possibly via a processing system), and the time taken to process any sensed data (via quality control, aggregation, combing multiple data sources, performing data analytics, etc.). This means that any decision taken on the sensed data (following simulation using the sensed data, and then following assessment/analysis of any results) will be made using data from the past.

Techniques according to embodiments exploit information lag to increase the amount of concurrent processing possible during simulation. In this way, the techniques herein are able to deliver results of simulations much faster.

As discussed above, it is often more realistic to use information from previous times as input to perform route planning (and other sub model routines); in this way, one is able to initiate route planning from time points that precede the time point at which the results are required.

FIGURE 5 illustrates the changes to the execution process relative to conventional techniques. The length of each rectangle represents elapsed time in which models are executed over 3 timesteps: *t*_{0,1}, *t*_{1,2}, and *t*_{2,3} (each timestep corresponding to a period between two points in time). The upper diagram shows a conventional process where, in *t*_{2,3}, route planning results are required, so execution of the main model stops while a route planner sub model executes.

Using the techniques herein according to embodiments, it is possible to reorder the overall simulation, initiating the route planner sub model using the results associated with a previous timestep (*t*_{0,1}) and executing the route planner sub model alongside (or in parallel with) the main model during the remainder of timesteps *t*_{0,1} and *t*_{1,2}. By the time the route planner sub model results are required during execution of the main model in timestep *t*_{2,3'}, the route planner results have been produced. As can be seen qualitatively from the change in lengths of the time steps in FIGURE 5 (note the main model component durations remain constant), the overall simulation execution time may be reduced.

The arrows in FIGURE 5 show the flow of data. For example, the route planning sub model input is state data from a main model component and the route planning sub model output is the route(s) based on the input state.

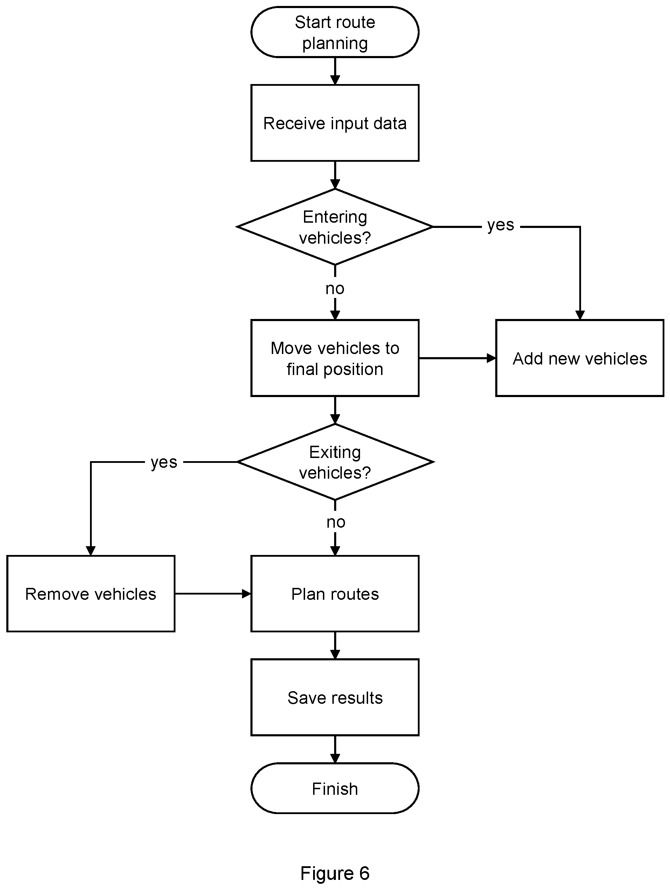

FIGURE 6 provides a schematic flow diagram of a simulation process as performed by an example route planner sub model. Of course, there may be multiple instances of route planner sub model execution over the execution of an entire CSS simulation.

**After starting,** a route planner sub model receives state data ("input data") from the main model (or a component thereof). These state data are valid for and representative of the current simulation time (start time point, *tₛ*) of the main model. These state data include, for example, current vehicle locations and speeds, current planned routes, traffic conditions, and any other required data. The state data includes an indicator of the simulation time for which the route planning is required (end time point, *tₑ*)*.* This time is required in this example as the vehicles within the simulation may have moved from their current positions by the time any new route may be needed.

Some vehicles may enter the simulation (that is, a new vehicle will enter the geographic region covered in the simulation) in the interval between *tₛ* and *tₑ.* Any such vehicles may be **added** to a list of vehicles for which route planning is required, as these vehicles will be active in the main model at *tₑ.*

Vehicles within the simulated geographic region are moved to an approximation of their locations at *tₑ* following their current routes. A simple model may be used since approximate locations (for example, with locations accurate to within a segment of road between junctions) - in combination with a sufficiently small interval between *tₛ* and *tₑ* - are typically sufficient to avoid large propagating errors. For example, vehicle moving may be performed using the current speeds and ignoring interactions of the vehicle under consideration with other vehicles and infrastructure (e.g., waiting times at junctions). Such simple models execute much faster than highly accurate main model methods.

Any vehicles that leave the geographic region or complete their routes may be removed, as no longer of concern for the main model.

The route planning may then be performed using the approximate locations for all vehicles as the starting points and using standard techniques. Results may be saved and the sub model processing terminates.

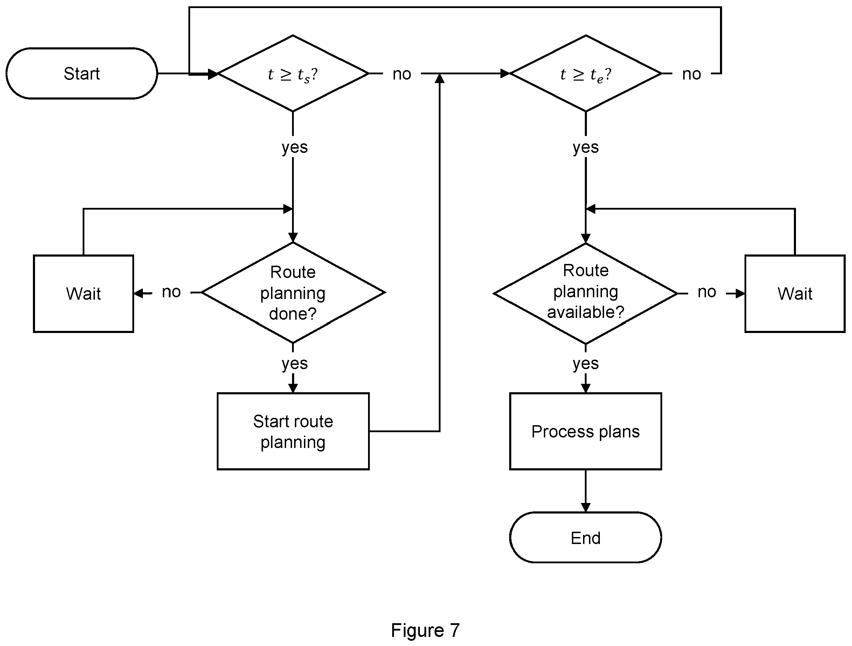

FIGURE 7 provides a schematic flow diagram of a simulation process as performed by the main model. With the techniques applied herein, one may ensure that updated routes (or, more broadly, the results produced by any sub model and the ancillary traffic simulation therein) are available for all times at which routing decisions are made prior to the execution of the main model at those simulation times. In this way, there is no wait or delay for route plans and simulation speeds and efficiencies may thus be improved.

**As above,** if it is required that a routing decision is to be taken at *tₑ* (e.g., by a main model component), route planning may be initiated at *tₛ* (*tₛ < tₑ*)*.* For improved accuracy, it is desirable that *tₛ* is as close to *tₑ* as practicable (of course, allowing for real world data collection lags and data processing lags) while guaranteeing that route planning results are available as required.

If the current simulation time point (t) is greater than the simulation time point at which route planning is to start (*tₛ*), the main model simulation process waits for any preceding route planning process to finish and then initiates a route planning sub model. For instance, the main model simulation process waits for a route planning process that is in respect of a preceding timestep to conclude. In an optimally initialised system, this should not be a concern and this waiting process should be unnecessary as, in such a system, any preceding route planning process should be complete.

If the current simulation time point (*t*) is greater than the time point for which planning is to be performed (*tₑ*)*,* this is indicative that the results of route planning are required. Again, if needed, the simulation process awaits route planning results to become available. When the route planning results are available, the main model simulation process then accepts input of the output route plans and begins any main model simulation procedure.

In some scenarios, it is possible that a route planning sub model takes a long time to execute. For instance, where there are a large number of vehicles in a geographic area and/or the geographic area is large with a complex road network. The "wait" operations as in FIGURE 7, as performed by main model components, may then be required to persist for a correspondingly long time. Although these prolonged waiting operations may ensure high accuracy of final simulation results, the benefits of this invention - as seen in concurrent execution of simulation processes in reduced durations - will necessarily be reduced. To overcome this, it is possible to dynamically adapt time intervals in advance of the time that a routing calculation is initiated.

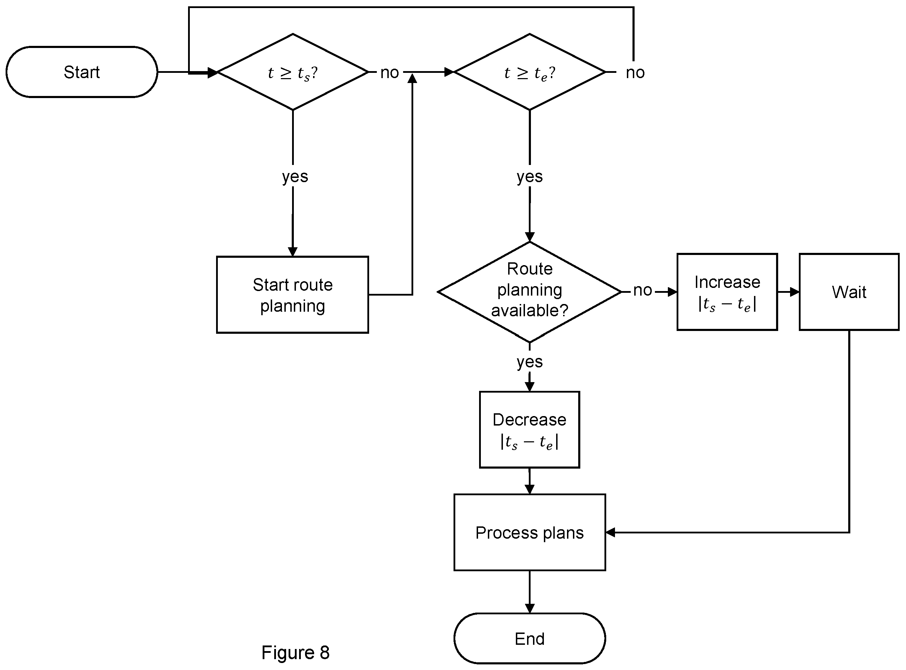

FIGURE 8 provides a schematic flow diagram of a simulation process as performed by the main model, with an example of dynamic adaptation of the time intervals (also referred to as the lags) between the time of the system state used by a sub model and the time that the results of the sub model are required. The flow largely corresponds to the processing as performed by the main model and described above with reference to FIGURE 7. For simplicity, **the processing** related to awaiting completion of any preceding route planning process in the left-hand branch is omitted from the diagram.

The simulation process may involve increase of the value of the time interval between the simulation time point for which the route planning sub model obtains traffic data (*tₛ*) and the time point for which the route planning sub model provides a route (*tₑ*)*.* That is, in the event that route plans are not yet (or not yet expected to be) available (despite being required), the process may increase the absolute value of (*tₑ-tₛ*) before "wait" operations are invoked (increasing the value before waiting). By dynamically adapting this time interval in response to the length of execution time spent "waiting", the computing means may reduce the overall simulation execution time. In this way, if there is a non-zero "wait" time, increasing the lag (*tₑ - tₛ*) has the effect of associating the sub model to an even earlier timestep, thereby giving the sub model more time to finish any computations before its results are required at the next time step. Similarly, if route plans are (or are expected to) available, this is indicative that the time interval could potentially be shortened, thereby associating the sub model with a more contemporaneous main model and/or data sources and increasing simulation accuracy.

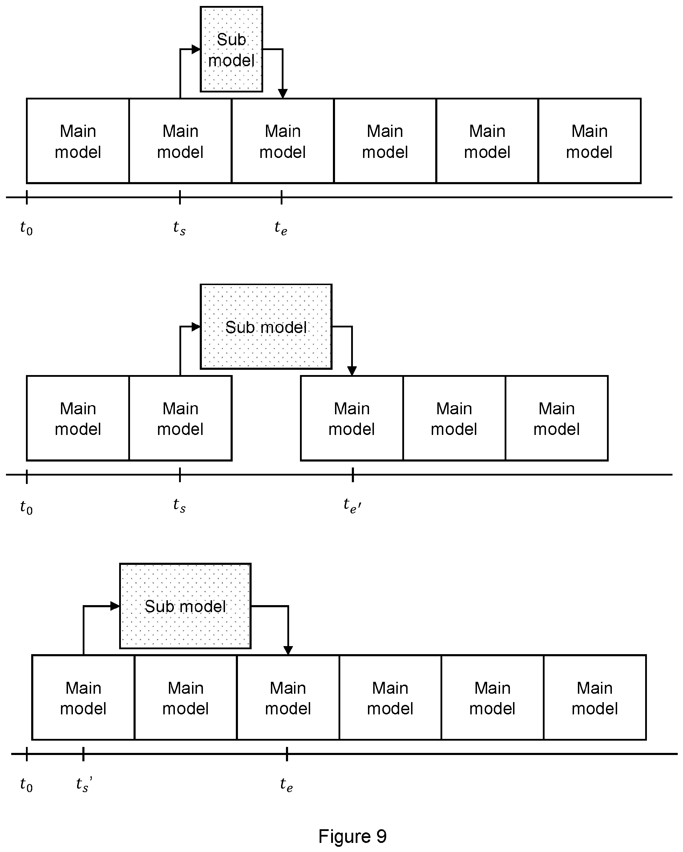

FIGURE 9 is a comparative schematic example of the progression of a traffic simulation with and without dynamic time interval adaptation. The top panel illustrates an idealised scenario, wherein no dynamic time interval adaption is required: the sub model obtains traffic data, begins processing at *tₛ*, and provides an output to the main model at time *tₑ.* As qualitatively indicated with the length of the sub model unit, the sub model output is available to the main model at the required time (*tₑ*)*.*

The middle panel illustrates a scenario without dynamic time interval adaptation, and in which the extended duration of sub model processing requires the main model to await available sub model results. The sub model obtains traffic data and begins processing at *tₛ* (as in the idealised scenario). The sub model, however, is not able to provide an output until a delayed time (*t_{e'}*)*,* which causes the need for a "wait" operation as indicated in the break in the main model process.

The lower panel illustrates a scenario with dynamic time interval adaptation, and in which the sub model requires an extended duration to complete processing. If the computing means is able to determine that sub model results will not be available at the required time (*tₑ*)*,* the computing means may increase the time interval (*tₑ* - *tₛ*) such that the sub model is associated with a timestep (*t*_{*s*'}) that precedes the timestep to which the sub model is otherwise associated (*tₛ*). The sub model then is able to acquire traffic data from the earlier timestep (*tₛ*') and provide an output for the original required time (*tₑ*)*.* Subsequent iterations of main model processing may retain such an increased time interval until it may be determined that the increase is no longer necessary (e.g., the simulated area becomes simpler and the sub model processing duration reduces accordingly). At this time, the computing means may reduce the time interval in a similar manner.

In one example working implementation, the discretized ODE solver SUMO provides the microscopic traffic simulation main model. Of course, other microscopic traffic simulation models and solvers are equally appropriate, including AIMSUN (Casas et al. 2010), MATsim (W Axhausen et al. 2016), ARCHISIM (Champion et al. 2001), and VISSIM (Fellendorf et al. 2010).

In one working implementation, computations required to update each agent's state are assigned to an individual Compute Unified Device Architecture (CUDA) core (floating point units in an NVIDIA graphics card) in a GPU via the framework's interface. GPUs such as NVIDIA's possess many thousand cores and may be integrated into a High-Performance Computing (HPC) cluster for a seamless scaling effect. Of course, other GPUs from other manufacturers, including AMD and Intel, may be used. Additionally or alternatively, CPUs may be used for executing main model components and for executing sub models.

One example of computational means used to implement aspects of embodiments has the following specifications: Intel Core i7-5930K, NVIDIA GeForce RTX 3090 (24 GiB), 64 GB host memory. The machine used is running Ubuntu 20.04.6 LTS.

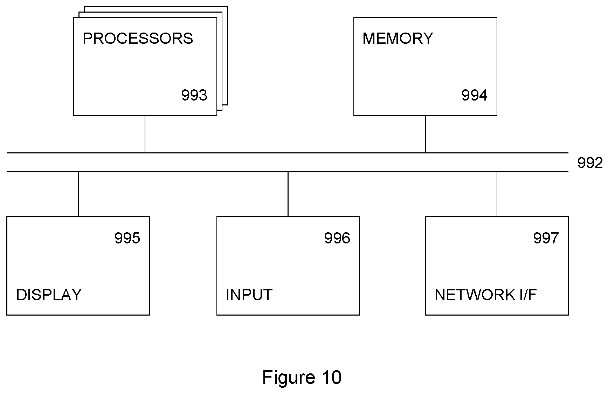

FIGURE 10 is a block diagram of a computing device, such as a data processing server, which embodies the present invention, and which may be used to implement a method for traffic simulation. The computing device comprises a plurality of processors or processing units 993 and memory, 994. Optionally, the computing device also includes a network interface 997 for communication with other computing devices, for example with other data storage devices or external data processing devices. An embodiment may be composed of a network of such computing devices. Network interface 997 is an example means for accepting input of traffic data.

Optionally, the computing device also includes one or more input mechanisms such as keyboard and mouse 996, and a display unit such as one or more monitors or screens 995. The components are connectable to one another via a bus 992.

The memory 994 may include a computer readable medium, a term which may refer to a single medium or multiple media (e.g., a centralised or distributed database and/or associated caches and servers) configured to carry computer-executable instructions or have data structures stored thereon. Computer-executable instructions may include, for example, instructions and data accessible by and causing a general purpose computer, special purpose computer, or special purpose processing device (e.g., one or more processors) to perform one or more functions or operations. Thus, the term "computer-readable storage medium" may also include any medium that is capable of storing, encoding or carrying a set of instructions for execution by the machine and that cause the machine to perform any one or more of the methods of the present disclosure. The term "computer-readable storage medium" may accordingly be taken to include, but not be limited to, solid-state memories, optical media and magnetic media. By way of example, and not limitation, such computer-readable media may include non-transitory computer-readable storage media, including Random Access Memory (RAM), Read-Only Memory (ROM), Electrically Erasable Programmable Read-Only Memory (EEPROM), Compact Disc Read-Only Memory (CD-ROM) or other optical disk storage, magnetic disk storage or other magnetic storage devices, flash memory devices (e.g., solid state memory devices).

The plurality of processors 993 is configured to control the computing device and execute processing operations, for example executing code stored in the memory to implement the method for traffic simulation and the associated simulation described here and in the claims. The memory 994 stores data being read and written by the plurality of plurality of processors 993. As referred to herein, a processor may include one or more general-purpose processing devices such as a microprocessor, central processing unit, or the like. The processor may include a complex instruction set computing (CISC) microprocessor, reduced instruction set computing (RISC) microprocessor, very long instruction word (VLIW) microprocessor, or a processor implementing other instruction sets or processors implementing a combination of instruction sets. The processor may also include one or more special-purpose processing devices such as an ASIC, a FPGA, a digital signal processor (DSP), network processor, or the like. In one or more embodiments, a processor is configured to execute instructions for performing the operations and steps discussed herein.

Display 995 may display a user interface. Input 996, in the form of a touchscreen or screen and keyboard and/or voice, may be used for user input. The user interface may be embodied as a user application shown on the display and optionally connected to the audio input/output of the user device for voice input and audio output. Local storage, for example of simulation parameters, may be provided by memory 994, and plurality of processors 993 may carry out background functions. The core functionality (execution of a simulation, for example) may preferably be implemented remotely from the user device, for example on the cloud.

The network interface (network I/F) 997 may be connected to a network, such as the internet, and is connectable to other such computing devices via the network. The network I/F 997 may control data input/output from/to other apparatus via the network. Other peripheral devices such as microphone, speakers, etc. may be included in the computing device.

Plurality of processors 993 may execute instructions stored on a portion of the memory 994 to exchange data between modules via bus 992 via network I/F 997 to external entities, such as traffic sensors.

Methods embodying the present invention may be carried out on a computing device such as that illustrated in FIGURE 10. Such a computing device need not have every component illustrated in FIGURE 10, and may be composed of a subset of those components. Methods embodying the present invention may be carried out by a single computing device in communication with one or more data storage servers via a network. The computing device may be a data storage itself storing preconfigured interventions, buffered sensor data, historical sensor data, multi-function optimisation models and parameters, etc.

A method embodying the present invention may be carried out by a plurality of computing devices operating in cooperation with one another. One or more of the plurality of computing devices may be a data storage server storing at least a portion of preconfigured simulation parameters, traffic network details, agent object data, etc.

The various methods described above may be implemented by a computer program. The computer program may include computer code (e.g., instructions) arranged to instruct a computer to perform the functions of one or more of the various methods described above. For example, the steps of the methods described in relation to FIGURE 4 may be performed by the computer code. The steps of the methods described above may be performed in any suitable order. The computer program and/or the code for performing such methods may be provided to an apparatus, such as a computer, on one or more computer readable media or, more generally, a computer program product. The computer readable media may be transitory or non-transitory. The one or more computer readable media could be, for example, an electronic, magnetic, optical, electromagnetic, infrared, or semiconductor system, or a propagation medium for data transmission, for example for downloading the code over the Internet. Alternatively, the one or more computer readable media could take the form of one or more physical computer readable media such as semiconductor or solid state memory, magnetic tape, a removable computer diskette, a random access memory (RAM), a read-only memory (ROM), a rigid magnetic disc, and an optical disk, such as a CD-ROM, CD-R/W or DVD. The instructions may also reside, completely or at least partially, within the memory 994 and/or within controller circuitry of plurality of processors 993 during execution thereof by the computing system, the memory 994 and the controller circuitry of plurality of processors 993 also constituting computer-readable storage media.

In an implementation, the modules, components and other features described herein may be implemented as discrete components or integrated in the functionality of hardware components such as ASICS, FPGAs, DSPs or similar devices.

A "hardware component" is a tangible (e.g., non-transitory) physical component (e.g., a set of one or more processors) capable of performing certain operations and may be configured or arranged in a certain physical manner. A hardware component may include dedicated circuitry or logic that is permanently configured to perform certain operations. A hardware component may comprise a special-purpose processor, such as an FPGA or an ASIC. A hardware component may also include programmable logic or circuitry that is temporarily configured by software to perform certain operations.

In addition, the modules and components may be implemented as firmware or functional circuitry within hardware devices. Further, the modules and components may be implemented in any combination of hardware devices and software components, or only in software (e.g., code stored or otherwise embodied in a machine-readable medium or in a transmission medium).

Unless specifically stated otherwise, as apparent from the following discussion, it is appreciated that throughout the description, discussions utilizing terms such as "receiving", "determining", "comparing", "enabling", "maintaining", "identifying", "obtaining", "accessing", or the like, refer to the actions and processes of a computer system, or similar electronic computing device, that manipulates and transforms data represented as physical (electronic) quantities within the computer system's registers and memories into other data similarly represented as physical quantities within the computer system memories or registers or other such information storage, transmission or display devices.

While certain embodiments have been described, these embodiments have been presented by way of example only, and are not intended to limit the scope of the inventions. Indeed, the novel methods and apparatuses described herein may be embodied in a variety of other forms; furthermore, various omissions, substitutions and changes in the form of methods and apparatus described herein may be made.

The following numbered statements are useful for understanding the present invention.

S1 A computer-implemented method for traffic simulation, the method comprising: accepting input of traffic data for a geographic area; executing a traffic simulation, wherein the traffic simulation comprises a main model configured to progress a traffic system through timesteps, and a sub model configured to perform an ancillary traffic simulation function for a later timestep using traffic data corresponding to an earlier timestep; and outputting a status of the traffic system.

S2 The computer-implemented method of statement S1, wherein the main model progresses the traffic system and the sub model performs the ancillary traffic simulation function in parallel.

S3 The computer-implemented method of any preceding statement, wherein executing the traffic simulation includes determining if the ancillary traffic simulation function for a preceding timestep has completed.

S4 The computer-implemented method of any preceding statement, further comprising dynamic adaptation of timestep duration.

S5 The computer-implemented method of any preceding statement, wherein the traffic simulation comprises a plurality of sub models configured to perform a corresponding plurality of ancillary traffic simulation functions for at least one later timestep using traffic data corresponding to at least one earlier timestep.

S6 The computer-implemented method of any preceding statement, wherein traffic data comprises data obtained from a digital twin of the geographic area.

S7 The computer-implemented method of any preceding statement, wherein the traffic data comprises sensor data, acquired from any or all of the following: GPS sensors or antennas; cellular network sensors or antennas; loop sensors; camera sensors; and vehicle parking sensors.

S8 The computer-implemented method of any preceding statement, wherein the traffic simulation model comprises a car-following model, and the traffic simulation model comprises a lane-changing model and/or a junction management model.

S9 A data processing apparatus comprising: means for accepting input of traffic data; and a processing unit configured to execute the computer-implemented method of any preceding statement.

S10 A computer program comprising instructions that, when the program is executed by a data processing apparatus, cause the data processing apparatus to carry out the method according to any of statements S1 to S8.

S11 A computer-readable medium comprising instructions that, when executed by a data processing apparatus, cause the data processing apparatus to carry out the method according to any of statements S1 to S8.

## Claims

1. A computer-implemented method for traffic simulation, the method comprising:
accepting input of traffic data for a geographic area;
executing a traffic simulation, wherein the traffic simulation comprises a main model configured to progress a traffic system through timesteps, and a sub model configured to perform an ancillary traffic simulation function for a later timestep using traffic data corresponding to an earlier timestep; and
outputting a status of the traffic system.

2. The computer-implemented method of claim 1, wherein the main model progresses the traffic system and the sub model performs the ancillary traffic simulation function in parallel.

3. The computer-implemented method of any preceding claim, wherein executing the traffic simulation includes determining if the ancillary traffic simulation function for a preceding timestep has completed.

4. The computer-implemented method of any preceding claim, further comprising dynamic adaptation of a time interval between the later timestep and the earlier timestep.

5. The computer-implemented method of any preceding claim, wherein the traffic simulation comprises a plurality of sub models configured to perform a corresponding plurality of ancillary traffic simulation functions for at least one later timestep using traffic data corresponding to at least one earlier timestep.

6. The computer-implemented method of any preceding claim, wherein traffic data comprises data obtained from a digital twin of the geographic area.

7. The computer-implemented method of any preceding claim, wherein the traffic data comprises sensor data, acquired from any or all of the following:
GPS sensors or antennas;
cellular network sensors or antennas;
loop sensors;
camera sensors; and
vehicle parking sensors.

8. The computer-implemented method of any preceding claim, wherein the traffic simulation model comprises a car-following model, and the traffic simulation model comprises a lane-changing model and/or a junction management model.

9. A data processing apparatus comprising:
means for accepting input of traffic data; and
a processing unit configured to execute the computer-implemented method of any preceding claim.

10. A computer program comprising instructions that, when the program is executed by a data processing apparatus, cause the data processing apparatus to carry out the method according to any of claims 1 to 8.

11. A computer-readable medium comprising instructions that, when executed by a data processing apparatus, cause the data processing apparatus to carry out the method according to any of claims 1 to 8.
